**Europäisches Patentamt**

**European Patent Office**

**Office européen des brevets**

(19)

(11) Veröffentlichungsnummer : **0 063 364**
**B1**

(12)  # EUROPÄISCHE PATENTSCHRIFT

(45) Veröffentlichungstag der Patentschrift :
**13.03.85**

(51) Int. Cl.⁴ : **H 03 G   3/30**

(21) Anmeldenummer : **82103163.0**

(22) Anmeldetag : **15.04.82**

---

(54) **Schaltungsanordnung zur Steuerung der Verstärkung einer ZF-Stufe.**

---

(30) Priorität : **18.04.81 DE 3115683**

(43) Veröffentlichungstag der Anmeldung :
**27.10.82 Patentblatt 82/43**

(45) Bekanntmachung des Hinweises auf die Patenterteilung : **13.03.85 Patentblatt 85/11**

(84) Benannte Vertragsstaaten :
**BE FR LU NL**

(56) Entgegenhaltungen :
**DE-A- 1 909 974**
**DE-A- 2 554 255**
**DE-A- 2 647 365**
**DE-B- 1 302 193**
**DE-B- 1 930 926**
**DE-B- 2 236 173**
**DE-B- 2 332 211**
**DE-B- 2 543 090**
**DE-B- 3 009 905**
**GB-A-   531 653**
**US-A- 3 688 198**
**US-A- 3 748 581**

(73) Patentinhaber : **Deutsche Thomson-Brandt GmbH**
**Hermann-Schwer-Strasse 3**
**D-7730 Villingen-Schwenningen (DE)**

(72) Erfinder : **Maier, Gerhard, Ing. grad.**
**Reutestrasse 19**
**Dauchingen (DE)**

## Beschreibung

Die Erfindung betrifft eine Schaltungsanordnung zur automatischen Verstärkungsregelung in einem Funkempfangsgerät, insbesondere einem Fernsehempfänger, zum Empfang dreier umschaltbarer Frequenzbänder.

Stand der Technik

Bekanntlich werden in derartigen Empfangsgeräten die HF-Eingangs- und Abstimmstufen von einem Signal aus dem ZF-Verstärker oder aus dem Demodulator bezüglich ihrer Verstärkung ab einer bestimmten Antenneneingangsspannung kontinuierlich geregelt. Dies geschieht mit sogenannten AVR-Schaltungen. Beispiele sind in den folgenden Publikationen zu finden : DE-OS 30 09 905, 25 43 090, 22 36 173 und DE-AS 19 30 926.

Die Tunerverstärkung beispielsweise in einem Rundfunk- oder Fernsehempfänger ist aber stark bandabhängig, weil besonders die Mischerverstärkung sehr mit der Arbeitsfrequenz und Oszillatorpegel schwankt. Das bewirkt, daß nur für die eine Frequenz, für die die verzögerte Tunerregelspannung in der Produktion eingestellt wurde, keine Übersteuerungs- oder Rauschprobleme existieren. Grundsätzlich leidet jede Regelung (z. B. AVR) darunter, daß aufgrund der unterschiedlichen Tunerverstärkung bandabhängig die Regeleinsatzpunkte unterschiedlich sind und deshalb gravierende Mängel hervorrufen. Dies ist auch bereits aus der DE-B-13 02 193 bekannt.

Neue postalische Forderungen hinsichtlich der Störsicherheit können dadurch allein mit der bisherigen Regelungsart nicht mehr erfüllt werden, weil als Ausgangsbasis für die Korrekt funktionierende AVR eine nicht konstante Systemverstärkung in den verschiedenen Frequenzbändern verwendet wird.

Die neueren Postvorschriften sind erlassen worden, weil die Frequenzbänder des Fernsehrundfunks immer enger mit Senderfrequenzen belegt werden. Insbesondere bei Einführung des Kabelfernsehens wirkt sich dieser bereichsabhängige, unterschiedliche Regeleinsatzpunkt nachteilig aus.

Die Probleme treten deshalb auf, weil wegen des Verstärkungsrückgangs beispielsweise in den Fernsehbändern IV/V der Regeleinsatzpunkt erst bei höheren HF-Eingangsspannungen erreicht wird. Dieser Verstärkungsrückgang ist bedingt durch die Eigenschaft der HF-Transistoren, deren Steilheit mit höheren Frequenzen abnimmt. Hierbei spielt auch der Einfluß der Abstimmdioden eine Rolle, die mit ihren Serienwiderständen die Güte der Filter verschlechtern. Das hat zur Folge, daß z. B. Eingangsfrequenzen starker Sender, die im Abstand von fünf Kanälen frequenzmäßig dicht neben der gerade eingestellten Oszillatorfrequenz liegen, an die Mischstufe gelangen und dadurch Mischprodukte bilden, die sich als Bildstörungen in Form von streifenförmigen Mustern bemerkbar machen.

In der DE-OS 23 32 211 wird eine Systemregelung angegeben in Verbindung mit unterschiedlichen Signalerzeugern. Hier wird eine andere Form einer AVR-Regelung mit konstanten Korrekturfaktoren gezeigt, wie sie der speziellen Aufgabenstellung der Anwendung gemäß dieser Anmeldung entspricht.

Der vorliegenden Erfindung lag die davon abweichende Aufgabe zugrunde, durch eine entsprechende Schaltungsanordnung die Regeleinsatzpunkte für die verschiedenen Frequenzbänder des HF-Abstimmteils automatisch bandabhängig auf gleiche Werte zu steuern, um damit die Verstärkungsunterschiede der Empfangseinrichtung auszugleichen. Die gesuchte Lösung sollte möglichst preiswert sein.

Diese Aufgabe wird für die angegebenen Oberbegriffe der beiden Ansprüche erfindungsgemäß nach deren Kennzeichen gelöst.

Indem jeweils die für das gerade gewählte Frequenzband erforderliche Schaltinformation für den Tuner als Steuersignal über ein Schaltglied direkt dem ZF-Vorstufentransistor zugeführt wird, wird die Verstärkung dieser Stufe bandabhängig verändert. Vorteilhafterweise wird hierdurch der Regeleinsatzpunkt des HF-Abstimmteils automatisch bandabhängig so gesteuert, daß dieser für alle Bänder etwa gleich früh in Bezug auf die HF-Eingangsspannung erreicht wird.

Je früher in einem solchen Gerät der Regeleinsatzpunkt gelegt wird, desto eher wird erreicht, daß ein Störsignal, insbesondere eine im Abstand von fünf Kanälen liegende Senderfrequenz, früher abgeregelt wird und damit schwächer an den Mischer gelangt. Die Folge davon ist, daß die Bildstörung nicht mehr auftritt, bzw. wesentlich geringer wird. Die erfindungsgemäße Lösung bringt keine wesentliche Verteuerung des Schaltungsaufwandes.

Beschreibung

Anhand der Zeichnungen werden Ausführungsbeispiele der Erfindung nachfolgend beschrieben. Es zeigen :

Figur 1 ein Blockschaltbild der Erfindung ;

Figur 2 eine Schaltung zur Steuerung der Stromgegenkopplung der ZF-Transistors ;

Figur 3 eine graphische Darstellung der Verstärkung in Abhängigkeit von der HF-Eingangsspannung des Tuners, und

Figur 4 eine Schaltung zur Steuerung der Spannungsgegenkopplung des ZF-Transistors.

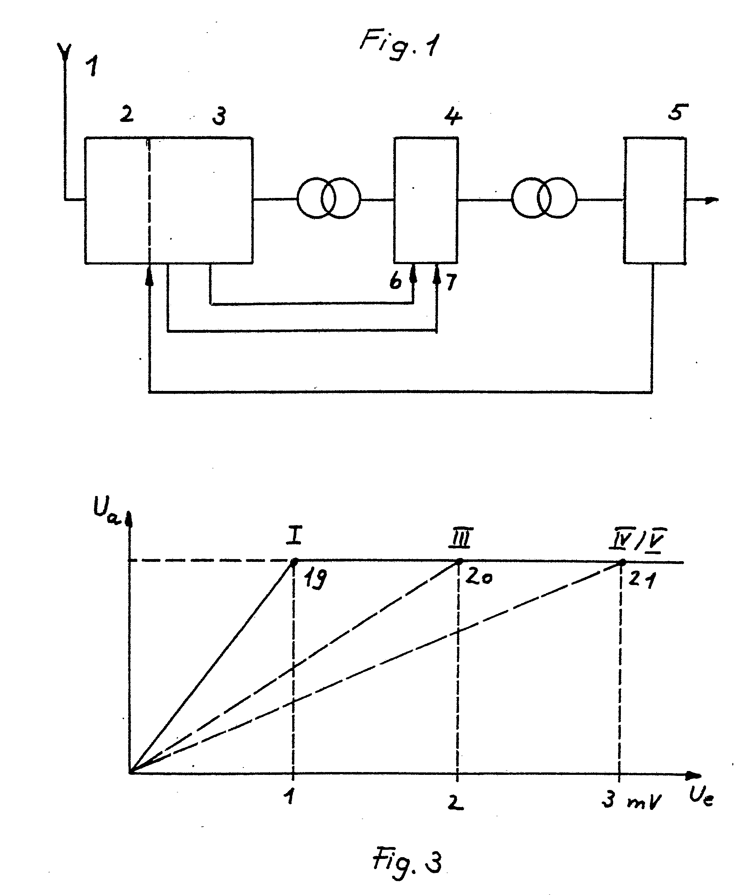

Figur 1 zeigt in einem prinzipiellen Blockschaltbild die bekannten Stufen am Beispiel eines Fernsehempfängers. Eine Antenne 1 speist eine HF-Vorstufe 2, die mit einer Abstimmeinheit 3, bestehend aus Mischer und Oszillator eine Einheit bildet. Ihr Ausgang ist über Filtermittel an den Eingang einer ZF-Vorstufe 4 gekoppelt, deren Ausgang wiederum über Filtermittel mit einem ZF-IC-Baustein 5 verbunden ist. Die so verstärkte ZF wird dem Demodulator zugeführt, der hier nicht mehr gezeigt ist. Aus dem Baustein 5 wird eine signalabhängige Größe zur üblichen Regelung an die HF-Vorstufe 2 zurückgeführt. Gemäß der Erfindung ist nun beispielsweise vorgesehen, aus der Abstimmeinheit 3 (Tuner) eine Tuner-Schaltinformation für die entsprechenden Fernsehbänder (I, III, IV/V) zu entnehmen und der ersten ZF-Stufe als Steuersignal zuzuleiten. Die Verstärkung der ZF-Vorstufe 4 wird in Abhängigkeit vom gerade eingeschalteten Band so gesteuert, daß der ZF-IC-Baustein 5 etwa gleich große Signale in allen Bändern erhält und dadurch der Regeleinsatzpunkt in der HF-Vorstufe 2 in den Bändern I, III, IV/V etwa gleich sein kann.

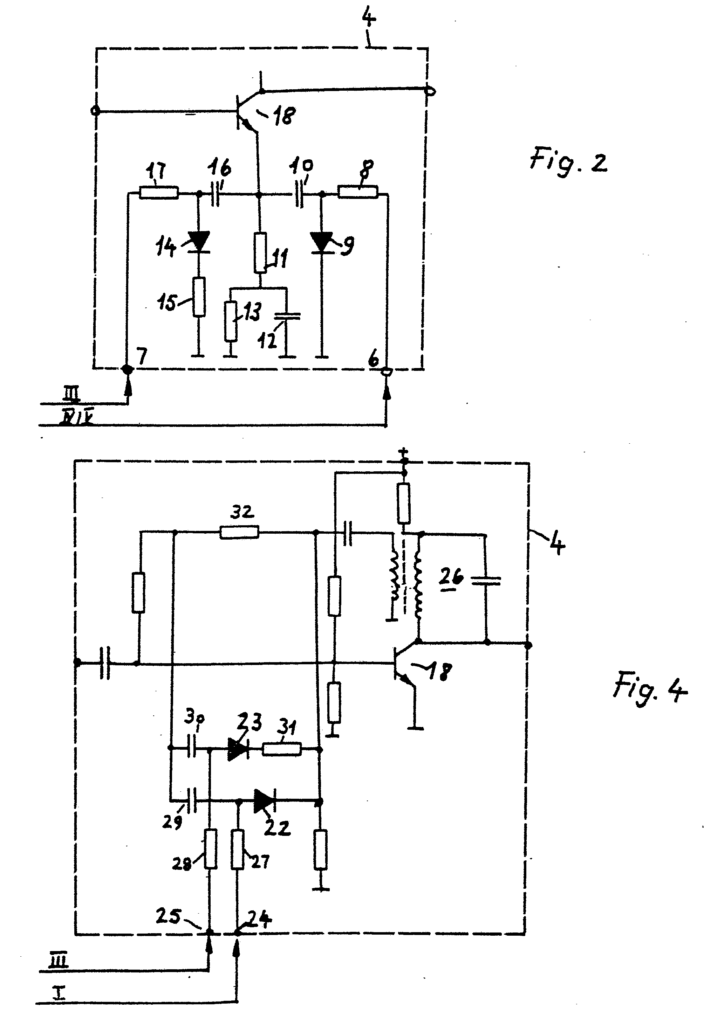

Um die gewünschte Steuerung der ZF-Vorstufe 4 vorzunehmen, wird die jeweilige Tuner-Schaltinformation für das Band III dem Anschluß 7 und die entsprechende für das Band IV/V dem Anschluß 6 gemäß Figur 2 zugeführt, die den ZF-Vorstufentransistor 18 mit seiner Stromgegenkopplungs-RC-Kombination 11, 12, 13 im Emitterkreis zeigt. Wird der Anschluß 6 über den Reihenwiderstand 8 aktiviert, so folgt ein Durchschalten der Diode 9 und der Emitter liegt HF-mäßig über den Kondensator 10 an Masse, weil das Gegenkopplungsglied, insbesondere der Widerstand 11 überbrückt ist. Wird hingegen der Anschluß 7 über den Reihenwiderstand 17 aktiviert, schaltet die Diode 14 durch und der Emitter liegt über den Kondensator 16 HF-mäßig und den Widerstand 15 an Masse.

Durch die Umschaltung der ZF-Vorstufe wird vermieden, daß der Regeleinsatzpunkt für das Band III bzw. IV/V erst bei 2 bzw. 3 im V Eingangsspannung liegt, wie das in Figur 3 prinzipiell dargestellt ist. Dies entspräche einem Verstärkungsverhältnis des Tuners von 1 : 3. Die Darstellung zeigt die Ausgangsspannung Ua beispielsweise am Mischer in Abhängigkeit von der Eingangsspannung Ue. Der Regeleinsatzpunkt 19 für das Band I liegt bei einer Eingangsspannung von Ue = 1 mV. Ohne Steuerung der ZF-Vorstufe 4 wurde der Regeleinsatzpunkt 20 für das Band III bei einer Eingangsspannung von Ue = 2 mV und der Regeleinsatzpunkt 21 für das Band IV/V sogar bei Ue = 3 mV liegen. Wenn es durch die erfindungsgemäße bandabhängige Steuerung der ZF-Vorstufe 4 gelingt, den jeweiligen Regeleinsatzpunkt 20 bzw. 21 auf den Regeleinsatzpunkt 19 zu korrigieren, dann wird eine knapp über einer Nutzsignalfrequenz liegende Störsignalfrequenz entsprechend schwächer am Mischer anliegen, da dieses Störsignal um den gleichen Faktor wie das Nutzsignal heruntergeregelt wird. Ein ohne die Steuerung des ZF-Vorstufentransistors als Bildstörung sichtbares Signal wird durch diese Steuerung bei richtiger Dimensionierung derart abgeschwächt, daß es nicht mehr sichtbar ist.

Es ist auch möglich, die Umschaltung der Verstärkung der ZF-Vorstufe nicht durch die in Figur 2 dargestellte Änderung der Stromgegenkopplung vorzunehmen, sondern durch eine Änderung der Spannungsgegenkopplung vom Kollektor zur Basis der Transistorstufe 18, wie in Figur 4 gezeigt. Hierbei werden die Dioden 22, 23 bandabhängig durch die an die Eingänge 24, 25 über Vorwiderstände 27, 28 gelegten Schaltspannungen durchgeschaltet, so daß die vom Ausgangsschwingkreis 26 abgenommene Gegenkopplungsspannung entsprechend der Verstärkung des Tuners durch mehr oder weniger wirksames Überbrücken des Gegenkopplungswiderstandes 32 durch den Kondensator 29 bzw. durch die Serienschaltung des Kondensators 30 mit dem Widerstand 31 geändert wird.

## Ansprüche

1. Schaltungsanordnung zur automatischen Verstärkungsregelung in einem Funkempfangsgerät, insbesondere einem Fernsehempfänger, zum Empfang dreier umschaltbarer Frequenzbänder (I, III, IV/V), dadurch gekennzeichnet, daß zur gleichbleibenden, bandunabhängigen Festlegung des Regeleinsatzpunktes immer das Band (I) mit der größten Verstärkung dient und daß die zur Umschaltung auf die verschiedenen Frequenzbänder (I, III, IV/V) verwendeten Bandschaltinformationen, die am Tuner (2, 3) anliegen, zusätzlich der ZF-Vorstufe (4) je nach Band über Vorwiderstände (8, 17) einer nach Masse führenden Diode (9) oder einer nach Masse führenden Serienschaltung einer Diode (14) und eines Widerstandes (15) zugeleitet werden, daß diese Anordnung jeweils über Kondensatoren (10, 16) einer das Emitterpotential des ZF-Vorstufentransistors (18) bestimmenden Stromgegenkopplungs-RC-Kombination (11, 12, 13) parallel liegt, wobei die Stromgegenkopplungs-RC-Kombination (11, 12, 13) durch die Diode (9) bei dem Band mit geringster Verstärkung vollständig überbrückt und bei dem verbleibenden Band III durch die Serienschaltung der Diode (14) und des Widerstandes (15) reduziert wird, wobei dies jeweils zum Zwecke der Verstärkungsänderung in der ZF-Vorstufe geschieht.

2. Schaltungsanordnung zur automatischen Verstärkungsregelung in einem Funkempfangsgerät, insbesondere einem Fernsehempfänger, zum Empfang dreier umschaltbarer Frequenzbänder (I, III, IV/V), dadurch gekennzeichnet, daß zur gleichbleibenden, bandunabhängigen Festlegung des Regeleinsatzpunktes immer das Band (I) mit der größten Verstärkung dient und daß die zur Umschaltung auf die verschiedenen Frequenzbänder (I, III, IV/V) verwendeten Bandschaltinformationen, die am Tuner (2, 3) anliegen, zusätzlich der ZF-Vorstufe (4) je nach Band über Vorwiderstände (27, 28) Schaltdioden (22, 23) zugeleitet werden, und daß dadurch einem die Spannungsgegenkopplung vom Kollektor zu Basis des ZF-Vorstufentransistors (18) bestimmenden Spannungsgegenkopplungswiderstand (32) bei dem Band (I) mit der größten Verstärkung ein Kondensator (29) direkt und bei dem verbleibenden Band (III) ein Widerstand (31) in Serie mit einem Kondensator (30) parallel geschaltet wird, wobei dies jeweils zum Zwecke der Verstärkungsänderung in der ZF-Vorstufe geschieht.

## Claims

1. Circuit arrangement for automatic gain control in a radioreceiver, especially a television receiver, for the reception of three switchable frequency bands (I, III, IV/V), characterized in that for the steady and band-independent determination of the inset point of control serves always the band with the highest gain and that the band switching informations used to switch to the different frequency bands (I, III, IV/V), which are applied to the tuner (2, 3), are being led additionally to the IF-prestage (4) dependent on the choosen band via drop resistance (8, 17) of a diode (9) connected to ground or via a series circuit of a diode (14) and a resistor (15) leading to ground, that this arrangement lays in parallel each time via capacitors (10, 16) of a current feedback coupling-RC-combination (11, 12, 13) determining the emitter potential of the IF-prestagetransistor (18), where by the current feed-back-RC-combination (11, 12, 13) is being completely by-passed by the diode (9) at the band with the lowest gain and being reduced at the remaining band III by the series circuit of the diode (14) and the resistor (15), where by this happens each time for the purpose of gain variation in the IF-prestage.

2. Circuit arrangement for automatic gain control in a radioreceiver, especially a television receiver, for the reception of three switchable frequency bands (I, III, IV/V), characterized in that for the steady and band-independent determination of the inset point of control serves always the band with the highest gain and that the band switching informations used to switch to the different frequency bands (I, III, IV/I), which are applied to the tuner (2, 3), are being led additionally to the IF-prestage (4) dependent on the choosen band via drop resistors (27, 28) to switching diodes (22, 23), and that thereby a voltage feed-back coupling resistor (32), which determines the voltage feedback coupling from collector to base of the IF-prestage transistor (18), at the band (I) having the greatest gain a capacitor (29) is being switched directly in parallel and at the remaining band (III) a resistor (31) in series with a capacitor (30) is being switched in parallel, whereby this happens each time for the purpose of gain variation in the IF-prestage.

## Revendications

1. Montage électronique pour régler automatiquement l'amplification dans un récepteur d'ondes hertziennes, en particulier, dans un récepteur de télévision conçu pour recevoir, par commutation, trois bandes de fréquences (I, III, IV/V), caractérisé en ce que pour fixer un point de réglage constant, indépendant de la bande de réception, on utilise toujours la bande (I) avec la plus grande amplification et en ce que les informations utilisées pour la commutation des différentes bandes de fréquences (I, III, IV/V), qui sont présentes sur le tuner (2, 3), sont appliquées non seulement à l'étage de préamplification FI (4), mais encore, selon la bande, à travers des résistances série (8, 17), à une diode (9) aboutissant à la masse, ou encore à un circuit série aboutissant à la masse composé d'une diode (14) et d'une résistance (15), en ce que ce circuit est branché en parallèle respectivement par les condensateurs (10, 16) d'un circuit RC de contre-réaction (11, 12, 13) déterminant le potentiel d'émetteur du transistor (18) de l'étage de préamplification FI, en ce que, dans la bande ayant la plus petite amplification, le circuit RC de contre-réaction de courant est complètement ponté par la diode (9), tandis que dans la bande restante III, cette contre-réaction est réduite par le circuit série comprenant la diode (14) et la résistance (15), ce qui précède se déroulant dans l'étage FI, afin de faire varier l'amplification dans cet étage FI.

2. Montage pour régler automatiquement l'amplification dans un récepteur d'ondes hertziennes, en particulier, dans un récepteur de télévision, pour recevoir trois bandes de fréquences commutables (I, III, IV/V), caractérisé en ce que pour fixer un point de réglage constant, indépendant de la bande de fréquences, on utilise toujours la bande (I) avec la plus grande amplification et en ce que pour la commutation sur les différentes bandes de fréquences (I, III, IV/V), les informations de commutation, qui sont présentes sur le tuner (2, 3), sont, en outre, appliquées à l'étage de préamplification FI (4), suivant la bande, à travers des résistances série (27, 28) et des diodes de commutation (22, 23), et en ce que, à travers une résistance de contre-réaction de tension (32) déterminant la tension entre le collecteur et la base du transistor de préamplification FI (18), dans la bande (I) ayant la plus grande amplification, un condensateur (29) est connecté directement, et dans la bande restante (III), une résistance (31) en série avec un condensateur (30) est branchée en parallèle, ce qui précède se déroulant respectivement, aux fins de variation de l'amplification, dans l'étage de préamplification FI.

Fig. 1

Fig. 3

Fig. 2

Fig. 4